Europäisches Patentamt

European Patent Office

Office européen des brevets

(11) Publication number: **0 210 033 B1**

## EUROPEAN PATENT SPECIFICATION

(45) Date of publication of patent specification: **05.02.92**  (51) Int. Cl.⁵: **H01G 4/12**

(21) Application number: **86305403.7**

(22) Date of filing: **14.07.86**

(54) **Dielectric thin films.**

(30) Priority: **16.07.85 JP 156519/85**

(43) Date of publication of application:
**28.01.87 Bulletin 87/05**

(45) Publication of the grant of the patent:
**05.02.92 Bulletin 92/06**

(84) Designated Contracting States:
**DE FR GB NL**

(56) References cited:
**JP-A-59 102 201**

**PATENT ABSTRACTS OF JAPAN, unexamined applications, vol. 8, no. 219, October 5, 1984; THE PATENT OFFICE JAPANESE GOVERNMENT, page 103 P 306**

**PATENT ABSTRACTS OF JAPAN, unexamined applications, vol. 8, no. 126 June 13, 1984**

**APPLICATIONS OF SURFACE SCIENCE, vol. 22/23, part 1, May 1985 North-Holland Publishing Company-Amsterdam YAMAMOTO-SHIMIZU "Characteristics of moisture - sensitive Ta2O5/Tio2 ceramic films" pages 827-838**

(73) Proprietor: **SONY CORPORATION**
**7-35 Kitashinagawa 6-Chome Shinagawa-ku Tokyo 141(JP)**

(72) Inventor: **Saito, Masaki c/o Patents Division Sony Corporation 6-7-35 Kitashinagawa Shinagawa-ku Tokyo 141(JP)**
Inventor: **Mori, Toshio c/o Patents Division Sony Corporation 6-7-35 Kitashinagawa Shinagawa-ku Tokyo 141(JP)**

(74) Representative: **Pilch, Adam John Michael et al**
**D. YOUNG & CO. 10 Staple Inn London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 210 033 B1

**Description**

This invention relates to dielectric thin films and to methods of forming such films; the invention is particularly suitable for the production of thin films having a high dielectric constant and high dielectric strength for use as a dielectric material in capacitors or the like.

A thin film composed of tantalum oxide ($Ta_2O_5$) and formed by chemical vapour deposition by oxygen-assisted thermal decomposition of tantalum ethylate ($Ta(OC_2H_5)$) has a relative dielectric constant of about 25 to 28 which is higher than that of a thin film made of $SiO_2$, $Si_3N_4$, or the like. Such a thin film may be employed advantageously for miniaturising a capacitive element or for improving the degree of integration of an integrated circuit. For comparison, the relative dielectric constant of $SiO_2$ is about 3.7 and that of $Si_3N_4$ is about 7.

Methods of forming a thin film of $Ta_2O_5$ include sputtering, chemical vapour deposition, and anodic oxidation for a Ta film. Of these methods, the chemical vapour deposition method is superior to the other methods in its adaptability to mass production.

Although a $Ta_2O_5$ thin film can be mass produced by a chemical vapour deposition method as described above, if the film thickness of the $Ta_2O_5$ film is less than 50nm (500 Å), a dimension which is commonly used in practice, the insulating property is poor, that is its dielectric strength is low. Thus, $Ta_2O_5$ thin films having very low film thicknesses cannot presently be used in practice.

When a $Ta_2O_5$ thin film formed by chemical vapour deposition is used as a capacitive element, noble metals such as gold, platinum or the like can be used as electrodes on both surfaces of this film, and high insulating properties and high dielectric strengths can be obtained. On the other hand, if metals and semiconductors such as aluminium, chromium, silicon or the like are used as electrodes, there arises the problem that the insulating properties deteriorate.

According to one aspect of the present invention there is provided a high dielectric constant thin film formed on a substrate, said thin film consisting of a mixture of a tantalum oxide and a titanium oxide in which the ratio of titanium (Ti) to tantalum (Ta) is in the range of 0.1 to 4 atomic percent.

According to another aspect of the present invention there is provided a method of forming a high dielectric constant thin film on a substrate, which method comprises depositing on the substrate a thin film consisting of a tantalum oxide and a titanium oxide by chemical vapour deposition, said thin film having a ratio of titanium (Ti) to tantalum (Ta) in the range of 0.1 to 4 atomic percent.

A preferred embodiment of the present invention provides an improved high dielectric constant thin film which has excellent insulating properties and dielectric strength. Such a thin film with a high dielectric constant can be used in a capacitor of miniature size. The high dielectric constant properties of the thin film make it possible to improve the degree of integration of an integrated circuit in which the capacitive element is included.

The invention will now be described by way of example with reference to the accompanying drawings, in which:

Figure 1 shows apparatus for manufacturing a high dielectric constant thin film according to an embodiment of the present invention;

Figures 2A to 2C are graphs respectively illustrating the relationships between X-ray diffraction intensity (2A), refractive index (2B) and dielectric strength (2C) of the thin film plotted against the growth temperature of the thin film;

Figure 3 is a graph showing the ratio between the flow rate of titanium alkoxide used in the synthesis and the Ti/Ta ratio in the thin film;

Figures 4A to 4C are graphs showing the relationship between electric field and leakage current using various types of electrodes;

Figure 5 is a graph showing the relationship between the Ti/Ta ratio in the thin film and its dielectric strength;

Figure 6 is a graph showing the relationship between the film thickness and the dielectric constant; and

Figure 7 is a graph showing the relationship between electric field intensity and leakage current.

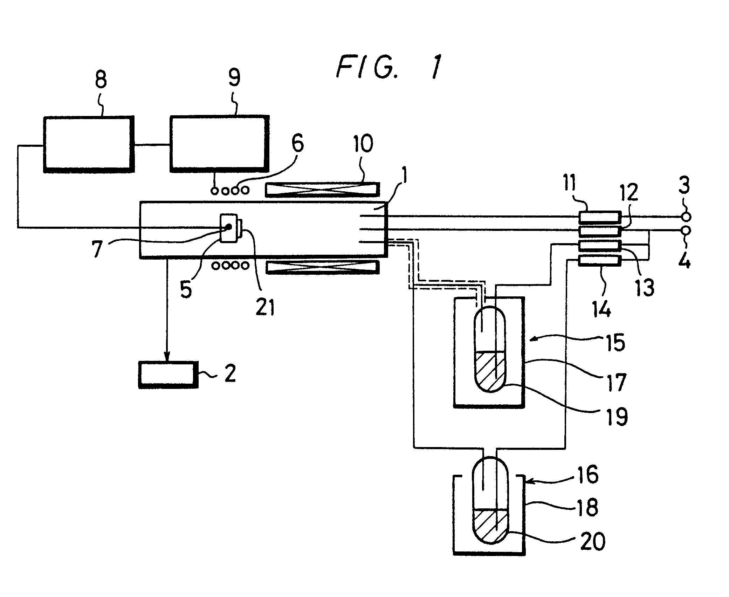

An embodiment of high dielectric constant thin film according to the present invention will be described with reference to a method of manufacturing the film. In Figure 1, there is shown a schematic diagram of apparatus used in the manufacturing method. The apparatus includes a reaction chamber 1, the inside of which is held at a substantial vacuum by means of a vacuum pump 2. Into the reaction chamber 1 there is supplied oxygen gas from an oxidising gas source 3 and a carrier gas such as Ar or He from a carrier gas source 4. These gases flow through first and second flow rate control valves 11 and 12, respectively. Similarly, the carrier gas from the carrier gas source 4 is supplied through third and fourth flow rate control valves 13 and 14 to first and second bubblers 15 and 16. The resulting vapours are supplied to the aforementioned reaction chamber 1. Constant temperature baths 17 and 18 surround the first and second bubblers 15 and 16. First and second cylinders 19 and 20 are used for bubbling.

A tantalum alkoxide, for example, tantalum pentaethylate $Ta(OC_2H_5)_5$ having a purity of 99.9999% is contained in the first cylinder 19 and is heated therein while a titanium alkoxide such as titanium tetra isopropylate $Ti(isoOC_3H_7)_4$ having a purity of 99.999% is contained in the second cylinder 20 and is heated therein.

A susceptor 5 made of graphite is located within the reaction chamber 1 and is heated by means of a high frequency induction coil 6 located outside the reaction chamber 1. The temperature of the susceptor 5 is detected by a thermal sensor 7 and a thermal regulating circuit 8 receives the signal from the sensor 7 and controls the current passing from a high frequency oscillation circuit 9 to the coil 6. The temperature of the susceptor 5 is thereby controlled to reach and remain at a desired value.

A substrate 21 is mounted on the susceptor 5. A preheater 10 is used to heat the reaction chamber 1 at a portion near the entrance through which the above-mentioned gases are supplied.

The apparatus may be operated under the following conditions.

| | |
|---|---|
| Pressure within the reaction chamber 1 | 0.3Torr (40 Pa) |
| Flow rate at the first flow rate control valve 11 | 100SCCM |
| Flow rate at the second flow rate control valve 12 | 500SCCM |
| Flow rate at the third flow rate control valve 13 | 150SCCM |
| Flow rate at the fourth flow rate control valve 14 | 50SCCM |
| Temperature of the first bubbler 15 | 125°C |
| Temperature of the second bubbler 16 | 20°C |
| Temperature of the pre-heater 10 | 250°C |
| Temperature of the susceptor 5 | 620°C |

The temperature of the supply tube from the first bubbler 15 to the reaction chamber 1 was kept at 170°C.

While $Ta(OC_2H_5)_5$ within the first bubbler 15 is liquid at room temperature to about 200°C, it is evaporated at 125°C under a pressure of 40 Pa (0.3Torr). The feeding rate to the reaction chamber 1 is controlled by the flow rate of the carrier gas through the third flow rate control valve 13. The flow rate of the $Ta(OC_2H_5)_5$ vapour evaporated from the bubbler 15 is kept at a predetermined temperature so as to prevent the vapour from being re-condensed.

The $Ti(isoOC_3H_7)_4$ within the second bubbler 16 is evaporated at 20°C under the same reduced pressure and, similarly, the flow rate of vapour into the reaction chamber 1 is controlled by the flow rate of the carrier gas through the fourth flow rate control valve 14.

Initially, the deposition reaction was carried out for six minutes without using the second bubbler 16 thereby to form a $Ta_2O_5$ thin film having a thickness of about 100nm (1000 Å) on the substrate 21.

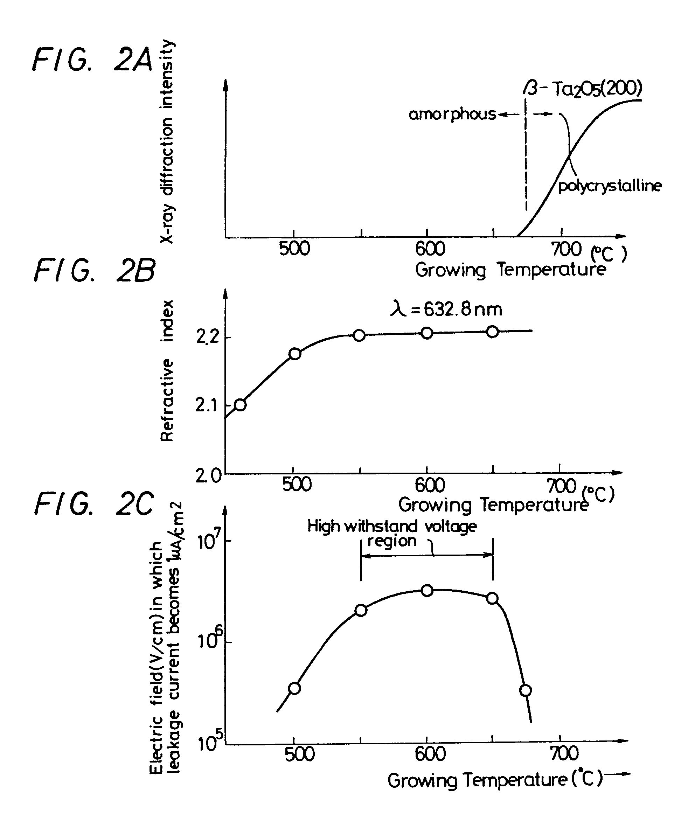

Figures 2A, 2B and 2C are graphs showing the effect of changing the temperature of the substrate 21 with the $Ta_2O_5$ thin film, the temperature being indicated on the abscissa. The X-ray diffraction intensity is indicated in Figure 2A, and the refractive index in Figure 2B. The electric field (V/cm) in which the leakage current is $1\mu$ $A/cm^2$ is indicated in Figure 2C on the ordinate thereof.

As seen in Figure 2, $Ta_2O_5$ having a high dielectric strength was obtained when the growing temperature (that is the temperature of the substrate 21) was in the range 550°C to 650°C, indicated by the double arrowed line in Figure 2C, and preferably in the range 600°C to 650°C.

The reason that the dielectric strength of the film is reduced at temperatures in excess of 650°C, as seen from the X-ray diffraction shown in Figure 2A, is that a polycrystalline portion is produced in the grown thin film so that the structure of the thin film is not homogeneous. Furthermore, the dielectric strength deteriorates at temperatures below about 550°C, as indicated by the decrease in the refractive index of the grown thin film shown in Figure 2B; only a thin film having a low density is formed because the grown thin film has porous portions therein or unreacted material mixed therein.

As will be understood from the foregoing results, it was confirmed that in order to obtain a $Ta_2O_5$ thin film having a high dielectric strength, the film must be grown at a temperature as high as possible in the range in which an amorphous film can be obtained. After the film was grown at a substrate temperature of 620°C for two minutes, a $Ta_2O_5$ thin film having a film thickness of about 20nm (200 Å) was obtained. When a Pt electrode having an area of 1 $mm^2$ was formed on the resulting thin film, a capacitance of 0.0116 $\mu F$ and having a value of tan $\delta$ of 0.5% was obtained. The dielectric breakdown voltage was 6.0V.

It will be understood that, if the growing temperature is selected appropriately, a $Ta_2O_5$ thin film having

a high dielectric strength is obtained. As mentioned previously, it is known that if the noble metals, such as Au, Pt or the like are used as electrodes deposited on both surfaces of this thin film, high insulating properties are obtained, whereas if other metals or semiconductors such as, for example, Al, Cr, Si or the like are used, the insulating properties deteriorate.

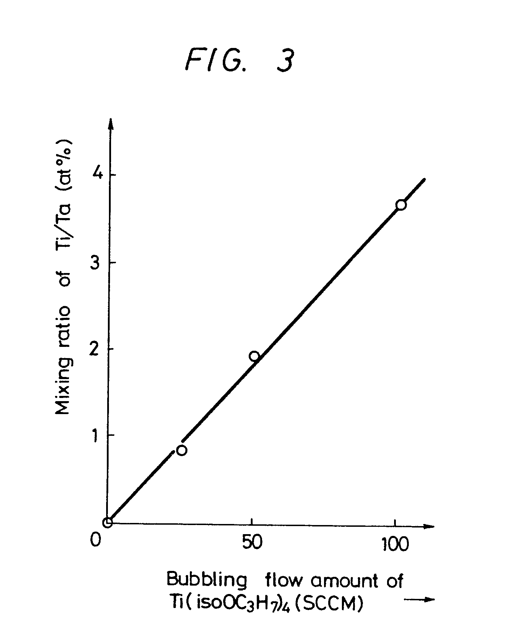

As shown in Figure 1, there is provided a second bubbler 16 by means of which $Ti(isoOC_3H_7)_4$ vapour is supplied to the reaction chamber 1. A thin film thus obtained was measured by ICP emission spectrochemical analysis to determine the atomic ratio of Ti/Ta and it was confirmed that a proportional relationship is established between the flow rate through the fourth flow rate control valve 14 and the added amount, as shown in Figure 3. It was also confirmed that if the temperature of the second bubbler 16 is changed, the resulting concentration is also changed.

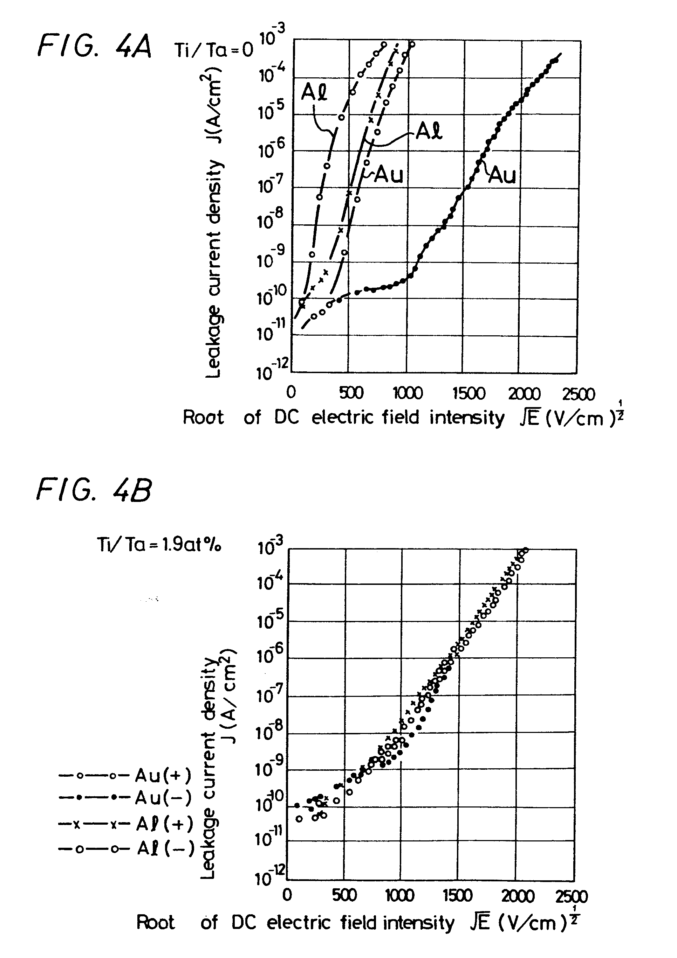

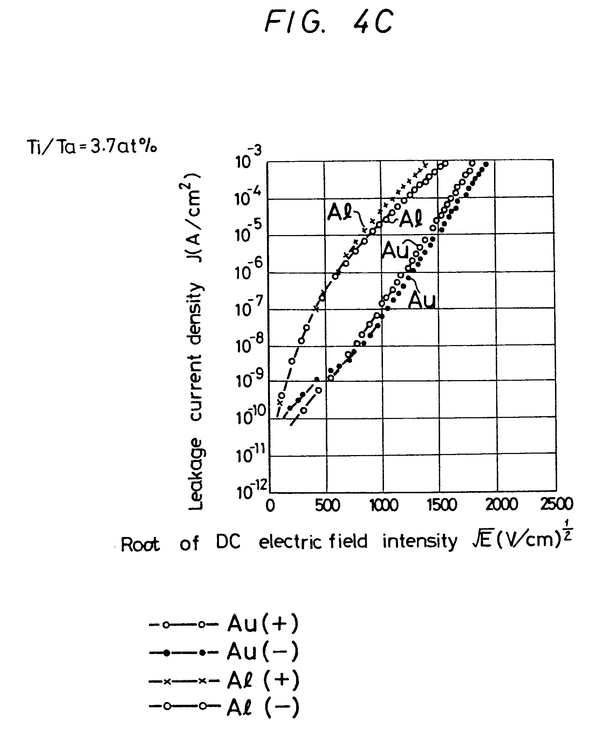

The relationship between a DC electric field intensity E of the thin film and the leakage current density J was measured at three concentration ratios of Ti/Ta, with different electrode materials, and with different electrode polarities. The measured results are indicated on Figures 4A to 4C. Figure 4A illustrates the instance where Ti/Ta = 0, Figure 4B shows the case where Ti/Ta is 1.9 atomic percent and Figure 4C illustrates the case where Ti/Ta is 3.7 atomic percent. Au and Al were used as the electrode materials and the respective polarities thereof are indicated as plus ( + ) and minus (-), respectively.

The electrode on the substrate side was formed by an Si substrate of the n-type, the resistivity of which was 0.02 ohm-cm, and a $Ta(OC_2H_5)_5$ thin film was formed on its (111) plane. In Figures 4A to 4C, the square root of the DC electric field E is plotted on the abscissa, while the leakage current density J is plotted logarithmically on the ordinate.

When the ratio Ti/Ta is zero, largely different characteristics are obtained dependent on the material of the electrodes and the polarity of the electric field applied. Particularly when using the structure $Al-Ta_2O_5-Si$ (which is frequently used as a capacitor), a high dielectric strength could not be obtained and so the structure could not be used effectively.

Figure 4B illustrates the case in which the ratio Ti/Ta is adjusted to be 1.9 atomic percent. From this figure, it will be clear that it is possible to obtain a capacitance which is not substantially affected by the material of the electrodes and the polarity of the DC electric field and which has a high overall dielectric strength. The fact that aluminium can be used instead of gold is also a substantial advantage in practice.

Figure 4C illustrates the situation in which the Ti/Ta ratio is about 3.7 atomic percent. In this example, it will be seen that the leakage current is increased, particularly in the case of the Al electrode.

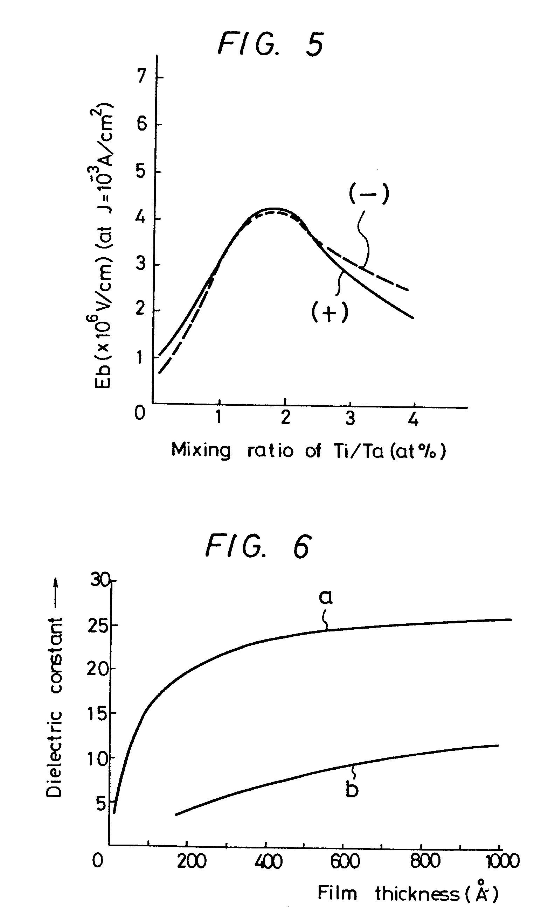

Figure 5 is a graph plotting the Ti/Ta ratio on the abscissa and the electric field intensity Eb on the ordinate. This graph shows the measured results of the change in the electric field intensity when the leakage current density J is $1 \times 10^{-3}$ $A/cm^2$ in relation to the ratio of Ti/Ta. From Figure 5 it will be seen that, for a practical dielectric strength of $2 \times 10^6$ V/cm, the atomic ratio should be greater than about 0.5 and less than about 3 atomic percent.

As noted previously, a $Ta_2O_5$ thin film can be produced by sputtering. Figure 6 is a graph showing the relationship between the average dielectric constant with respect to the thin film made by sputtering and a thin film made according to this embodiment of the present invention. In the graph of Figure 6, a curve a indicates the measured results of the thin film made according to this embodiment of the present invention, while a curve b indicates the results obtained from the thin film made by the sputtering method.

It will be seen from Figure 6 that the dielectric constant of the thin film made by the sputtering method is considerably lower as compared with that made according to the present embodiment. The reason for this is that the sputtering method produces a layer having a film thickness of about 17nm (170 Å) and a low dielectric constant and which may consist of $SiO_2$. In accordance with the chemical vapour deposition method embodying this invention, however, there is almost no layer having a low dielectric constant so that an overall high dielectric constant is obtained. In the graph of Figure 6, the curve a indicates the calculated value in the case where an $SiO_2$ film or layer having a film thickness of about 1.2nm (12 Å) is assumed to have been produced.

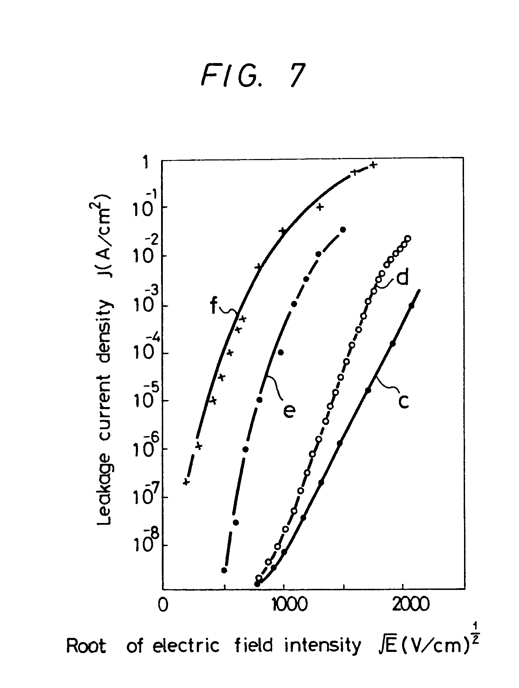

Figure 7 shows the relationship between the square root of the DC electric field E and the leakage current density J with respect to the thin film of the present embodiment and films produced by other methods. In the graph of Figure 7, a curve c indicates the measured results of the present thin film, a curve d indicates the results of a thin film produced by a magnetron sputtering method, a curve e indicates the results obtained from a thin film made by a Ta thermal oxidation method and a curve f indicates the results obtained from a thin film made by another chemical vapour deposition method. From the curves c to f, it was confirmed that thin films made according to the present invention have a higher dielectric strength as compared with films made by other methods.

As described above, high dielectric thin films made according to the present invention have high dielectric constants, and can constitute so-called MIS (metal insulator semiconductor) capacitors having high dielectric strength. Therefore, such capacitors can be miniaturised and the above-described techniques serve to improve the so-called integration degree of integrated circuits and the like.

## Claims

1. A high dielectric constant thin film formed on a substrate, said thin film consisting of a mixture of a tantalum oxide and a titanium oxide in which the ratio of titanium (Ti) to tantalum (Ta) is in the range of 0.1 to 4 atomic percent.

2. A method of forming a high dielectric constant thin film on a substrate, which method comprises depositing on the substrate a thin film consisting of a tantalum oxide and a titanium oxide by chemical vapour deposition, said thin film having a ratio of titanium (Ti) to tantalum (Ta) in the range of 0.1 to 4 atomic percent.

3. A method according to claim 2, wherein said chemical vapour deposition includes the step of oxygen-assisted pyrolysis of a tantalum alkoxide and a titanium alkoxide.

4. A method according to claim 3, wherein said tantalum alkoxide is tantalum pentaethylate and said titanium alkoxide is titanium tetra isopropylate.

5. A capacitor comprising a high dielectric constant thin film formed on a substrate in accordance with the method of any one of claims 2 to 4.

## Revendications

1. Film mince à constante diélectrique élevée formé sur un substrat, ledit film mince étant constitué par un mélange d'oxyde de tantale et d'oxyde de titane dans lequel le rapport de titane (Ti) sur le tantale (Ta) se situe dans une plage qui va de 0,1 à 4% en nombre d'atomes.

2. Procédé de formation d'un film mince à constante diélectrique élevée sur un substrat, le procédé comprenant le dépôt sur le substrat d'un film mince constitué par de l'oxyde de tantale et par de l'oxyde de titane au moyen d'un dépôt chimique en phase vapeur, ledit film mince ayant un rapport de titane (Ti) sur le tantale (Ta) qui se situe dans une plage qui va de 0,1 à 4% en nombre d'atomes.

3. Procédé suivant la revendication 2, dans lequel ledit dépôt chimique en phase vapeur inclut l'étape de pyrolyse assistée par oxygène d'un alkoxyde de tantale et d'un alkoxyde de titane.

4. Procédé selon la revendication 3, dans lequel ledit alkoxyde de tantale est du pentaéthylate de tantale et ledit alkoxyde de titane est du tétraisopropylate de titane.

5. Capacité comprenant un film mince à constante diélectrique élevée formée sur un substrat selon le procédé d'une quelconque des revendications 2 à 4.

## Patentansprüche

1. Auf einem Substrat gebildete Dünnschicht mit hoher Dielektrizitätskonstante, bestehend aus einer Mischung aus Tantaloxid und Titanoxid, in der das Verhältnis von Titan (Ti) zu Tantal (Ta) im Bereich von 0,1 bis 4 Atomprozent liegt.

2. Verfahren zur Herstellung einer Dünnschicht mit hoher Dielektrizitätskonstante, umfassend das Aufbringen einer Dünnschicht aus Tantaloxid und Titanoxid auf ein Substrat durch chemisches Aufdampfen, wobei in der Dünnschicht das Verhältnis von Titan (Ti) zu Tantal (Ta) im Bereich von 0,1 bis 4 Atomprozent liegt.

3. Verfahren gemäß Anspruch 2, wobei das chemische Aufdampfen die Stufe der sauerstoff-unterstützten Pyrolyse von einem Tantalalkoxid und einem Titanalkoxid einschließt.

4. Verfahren gemäß Anspruch 3, wobei das Tantalalkoxid Tantalpentaethylat und das Titanalkoxid Titantetraisopropylat sind.

5. Kondensator, bestehend aus einer auf einem Substrat aufgebrachten Dünnschicht mit hoher Dielektrizitätskonstante gemäß einem jeden der Ansprüche 2 bis 4.

FIG. 1

EP 0 210 033 B1

## FIG. 2A

## FIG. 2B

## FIG. 2C

FIG. 3

FIG. 4A  Ti/Ta=0

Aℓ

Aℓ

Au

Au

Leakage current density J(A/cm²)

Root of DC electric field intensity √E (V/cm)^½

FIG. 4B

Ti/Ta=1.9at%

—○——○— Au(+)
—•——•— Au(−)
—x——x— Aℓ(+)
—○——○— Aℓ(−)

Leakage current density J(A/cm²)

Root of DC electric field intensity √E (V/cm)^½

## FIG. 4C

Ti/Ta=3.7at%

Leakage current density  J(A/cm²)

Root  of  DC  electric field  intensity  $\sqrt{E}$(V/cm)$^{\frac{1}{2}}$

−o——o− Au(+)
−●——●− Au(−)
−×——×− Aℓ(+)
−o——o− Aℓ(−)

## FIG. 5

## FIG. 6

# FIG. 7

Leakage current density $J(A/cm^2)$

Root of electric field intensity $\sqrt{E}(V/cm)^{\frac{1}{2}}$